# EUROPEAN PATENT APPLICATION

(11) **EP 4 636 742 A1**
(43) Date of publication of application: **22.10.2025**
(21) Application number: 25162336.9
(22) Date of filing: 07.03.2025
(51) Int. Cl.: G09G 3/00

(54) **DISPLAY DEVICE**

(30) Priority: 17.04.2024 KR 20240051294
(71) Applicant: Samsung Display Co., Ltd., Yongin-si, Gyeonggi-do 17113 (KR)
(72) Inventor: Ki, Se Dae, 17113 Yongin-si, Gyeonggi-do (KR); Lee, Hyung Pil, 17113 Yongin-si, Gyeonggi-do (KR); Chang, Geun Yeong, 17113 Yongin-si, Gyeonggi-do (KR)
(74) Representative: Gulde & Partner

(57) **Abstract**

A display device includes a display panel including a plurality of pixels disposed in a display area, and a driver integrated circuit electrically connected to the plurality of pixels, where the driver integrated circuit includes a plurality of pads spaced apart from each other, and a driving chip including a plurality of contact pins electrically contacting the plurality of pads, respectively. Each of the plurality of pads includes a first pad area electrically contacting a corresponding contact pin among the plurality of contact pins, and a second pad area partitioned from the first pad area and not overlapping the corresponding contact pin in a plan view.

## Description

### BACKGROUND

### 1. Field

The disclosure relates to a display device.

### 2. Description of the Related Art

A display device is a device that displays an image. The display device may include various components for displaying the image. In the display device, the various components may electrically contact each other. In this case, when electrical contact is not effectively maintained between the components, a defect may occur in the image displayed on the display device. Therefore, reliability of the display device may be reduced.

### SUMMARY

A test device may be used to determine or detect an electrical contact defect between components of a display device. The test device may include a plurality of test pins. The plurality of test pins may electrically contact a plurality of pads of the display device.

In this case, when contact reliability between the plurality of test pins and the plurality of pads is not sufficiently secured, test reliability of the display device may be reduced.

The disclosure provides a display device with improved test reliability and a method of testing the display device.

According to embodiments of the disclosure, a display device includes a display panel including a plurality of pixels disposed in a display area, and a driver integrated circuit (DIC) electrically connected to the plurality of pixels, where the driver integrated circuit includes a plurality of pads spaced apart from each other, and a driving chip including a plurality of contact pins electrically contacting the plurality of pads, respectively. In such embodiments, each of the plurality of pads includes a first pad area electrically contacting a corresponding contact pin among the plurality of contact pins, and a second pad area partitioned from the first pad area and not overlapping the corresponding contact pin in a plan view.

In an embodiment, in the plan view, a width of the contact pin in a first direction may be less than a width of the second pad area in the first direction, and the first direction may be a direction perpendicular to a second direction, which is an extension direction of the corresponding contact pin.

In an embodiment, in the plan view, a width of the second pad area in the second direction may be greater than the width of the corresponding contact pin in the first direction.

In an embodiment, second pad areas of the plurality of pads may be arranged along the first direction.

In an embodiment, a separation distance between adjacent second pad areas among the second pad areas may be constant.

In an embodiment, in the plan view, an area of the second pad area may be less than an area of the first pad area.

In an embodiment, the driver integrated circuit may further include a first layer disposed under the plurality of pads, and a second layer disposed on the first layer, covering an edge of each of the plurality of pads, and defining an opening exposing an upper surface of each of the plurality of pads.

In an embodiment, the driver integrated circuit may further include a dam structure disposed between the first pad area and the second pad area in the opening.

In an embodiment, the dam structure may partition the opening into a first opening and a second opening, the first opening may expose the first pad area, and the second opening may expose the second pad area.

In an embodiment, the driver integrated circuit may further include a solder member disposed in the first pad area of each of the plurality of pads, where each of the plurality of pads is bonded to the corresponding contact pin by the solder member.

According to embodiments of the disclosure, a method of testing a display device is provided. In such embodiments, the display device includes a display panel including a plurality of pixels disposed in a display area, and a driver integrated circuit electrically connected to the plurality of pixels, where the driver integrated circuit includes a plurality of pads spaced apart from each other, and a driving chip including a plurality of contact pins electrically contacting the plurality of pads, respectively. In such embodiments, each of the plurality of pads includes a first pad area electrically contacting a corresponding contact pin among the plurality of contact pins, and a second pad area partitioned from the first pad area and not overlapping the corresponding contact pin in a plan view. In such embodiments, the method includes contacting a plurality of test pins of a test device to the plurality of pads, respectively.

In an embodiment, each of the plurality of test pins may contact the second pad area.

In an embodiment, the plurality of test pins may correspond to the plurality of pads with a one-to-one correspondence.

In an embodiment, in the plan view, a width of the contact pin in a first direction may be less than a width of the second pad area in the first direction, and the first direction may be a direction perpendicular to a second direction, which is an extension direction of the corresponding contact pin.

In an embodiment, in the plan view, a width of the second pad area in the second direction may be greater than the width of the corresponding contact pin in the first direction.

In an embodiment, the driver integrated circuit may further include a first layer disposed under the plurality of pads, and a second layer disposed on the first layer, covering an edge of each of the plurality of pads, and defining an opening exposing an upper surface of each of the plurality of pads.

In an embodiment, the driver integrated circuit may further include a dam structure disposed between the first pad area and the second pad area in the opening.

In an embodiment, the dam structure may partition the opening into a first opening and a second opening, the first opening may expose the first pad area, and the second opening may expose the second pad area.

In an embodiment, the driver integrated circuit may further include a solder member disposed in in the first pad area of each of the plurality of pads, where each of the plurality of pads is bonded to the corresponding contact pin by the solder member.

In an embodiment, the method may further include displaying a test image in the display area based on a test image signal provided from the plurality of test pins, and determining a connection defect of the driving chip based on the test image.

In the display device according to embodiments of the disclosure, each of the plurality of pads may include the first pad area and the second pad area partitioned from the first pad area.

In such embodiments, the second pad area may be an area for contact with a test pin of the test device, and the first pad area may be an area for contact with a contact pin of the driving chip. In such embodiments, an area (that is, the second pad area) for contact with the test pin and an area (that is, the first pad area) for contact with the contact pin may be partitioned from each other and provided in one pad.

Therefore, the test pin may effectively contact the pad in the second pad area without being disturbed by the contact pin. Accordingly, test reliability of the display device may be improved.

### BRIEF DESCRIPTION OF THE DRAWINGS

The above and other features of the disclosure will become more apparent by describing in further detail embodiments thereof with reference to the accompanying drawings, in which:
FIG. 1 is a block diagram illustrating a display device according to embodiments of the disclosure;
FIG. 2 is a block diagram illustrating one sub-pixel among sub-pixels included in the display device of FIG. 1;
FIG. 3 is a plan view illustrating a display panel of the display device of FIG. 1;
FIG. 4 is an enlarged plan view of an area AA of FIG. 3;
FIG. 5 is a cross-sectional view taken along line I1-I1' of FIG. 4; and
FIGS. 6 to 12 are diagrams illustrating an embodiment of a test method for testing the display panel of FIG. 3.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

Throughout the specification, in a case where a portion is "connected" to another portion, the case includes not only a case where the portion is "directly connected" but also a case where the portion is "indirectly connected" with another element interposed therebetween.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. "At least one of X, Y, and Z" and "at least one selected from X, Y, and Z" may be interpreted as one X, one Y, one Z, or any combination of two or more of X, Y, and Z (for example, XYZ, XYY, YZ, and ZZ). It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and thus the spatially relative terms used herein are interpreted according thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

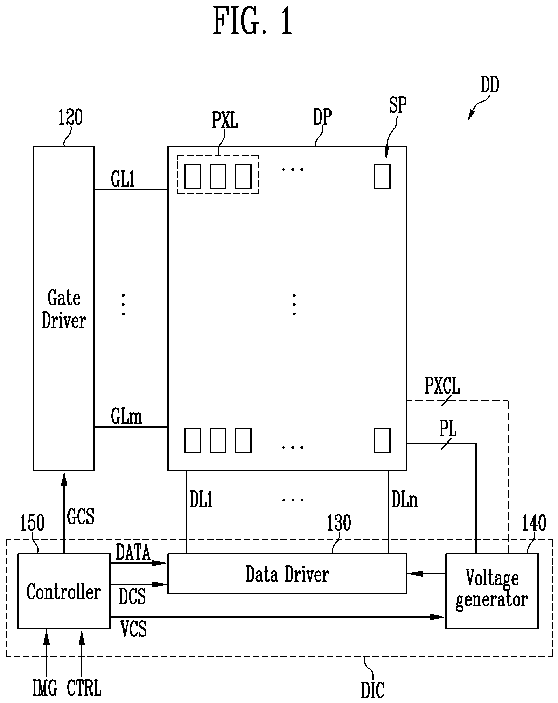

FIG. 1 is a block diagram illustrating a display device according to embodiments of the disclosure.

Referring to FIG. 1, an embodiment of the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn. Here, m and n are integers greater than 1.

The sub-pixels SP may generate light of two or more colors. In an embodiment, for example, each of the sub-pixels SP may generate light such as red, green, blue, cyan, magenta, or yellow. The sub-pixels each may generate light of a single color, and the entirety of the sub-pixels may generate light of two or more (e.g., three) colors.

Two or more sub-pixels among the sub-pixels SP may configure one pixel PXL. In an embodiment, for example, the pixel PXL may include three sub-pixels as shown in FIG. 1. The pixel PXL may emit light of various colors and various luminances corresponding to a combination of light emitted from the sub-pixels included in the pixel PXL.

The gate driver 120 may be connected to the sub-pixels SP arranged in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, or the like.

In an embodiment, the gate driver 120 may be disposed on one side of the display panel DP. However, embodiments are not limited thereto. In another embodiment, for example, the gate driver 120 may be divided into two or more physically and/or logically divided drivers, and such drivers may be disposed on one side of the display panel DP and another side of the display panel DP opposite the one side. As described above, the gate driver 120 may be disposed around the display panel DP in various shapes according to embodiments.

The data driver 130 may be connected to the sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock, a source output enable signal, or the like.

The data driver 130 may receive voltages from the voltage generator 140. The data driver 130 may apply data signals having grayscale voltages corresponding to the image data DATA to the first to n-th data lines DL1 to DLn using the received voltages. When the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image by light generated from the sub-pixels SP.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may be configured to generate a plurality of voltages and provide the generated voltages to components of the display device DD, such as the gate driver 120, the data driver 130, and the controller 150. The voltage generator 140 may generate the plurality of voltages by receiving an input voltage and regulating the received voltage.

In an embodiment, the voltage generator 140 may generate a first power voltage and a second power voltage. The generated first and second power voltages may be provided to the sub-pixels SP through power lines PL. In another embodiment, at least one of the first and second power voltages may be provided from the outside of the display device DD.

In addition, the voltage generator 140 may provide various voltages and/or signals. In an embodiment, for example, the voltage generator 140 may provide one or more initialization voltages applied to the sub-pixels SP. In an embodiment, for example, during a sensing operation for sensing electrical characteristics of transistors and/or light emitting elements of the sub-pixels SP, a predetermined reference voltage may be applied to the first to n-th data lines DL1 to DLn, and the voltage generator 140 may generate the reference voltage and transmit the reference voltage to the data driver 130. In an embodiment, for example, during a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In an embodiment, as shown in FIG. 1, the pixel control lines PXCL may be connected between the voltage generator 140 and the display panel DP, but embodiments are not limited thereto. In an embodiment, for example, the pixel control lines PXCL may be connected between the gate driver 120 and the display panel DP. In such an embodiment, the pixel control signals may be transmitted from the voltage generator 140 to the pixel control lines PXCL through the gate driver 120.

The controller 150 may control overall operations of the display device DD. The controller 150 may receive input image data IMG and a control signal CTRL corresponding thereto from the outside. The controller 150 may provide the gate control signal GCS, the data control signal DCS, and the voltage control signal VCS in response to the control signal CTRL.

The controller 150 may convert the input image data IMG so that the input image data IMG is suitable for the display device DD or the display panel DP and output the image data DATA. In embodiments, the controller 150 may output the image data DATA by aligning the input image data IMG so that the input image data IMG is suitable for the sub-pixels SP of a row unit.

Two or more components of the data driver 130, the voltage generator 140, and the controller 150 may be mounted on one integrated circuit. In an embodiment, as shown in FIG. 1, the data driver 130, the voltage generator 140, and the controller 150 may be included in a driver integrated circuit DIC. In such an embodiment, the data driver 130, the voltage generator 140, and the controller 150 may be functionally divided components in one driver integrated circuit DIC. In other embodiments, at least one selected from the data driver 130, the voltage generator 140, and the controller 150 may be provided as a component distinguished from the driver integrated circuit DIC.

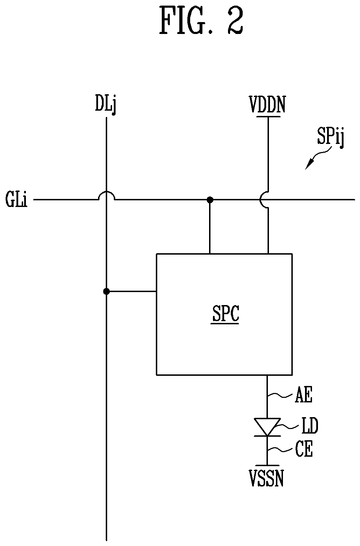

FIG. 2 is a block diagram illustrating one sub-pixel among the sub-pixels included in the display device of FIG. 1. In FIG. 2, among the sub-pixels SP of FIG. 1, a sub-pixel SPij arranged in an i-th row (i is an integer greater than or equal to 1 and less than or equal to m) and a j-th column (j is an integer greater than or equal to 1 and less than or equal to n) is shown as an example.

Referring to FIG. 2, an embodiment of the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL of FIG. 1 and receives the first power voltage. The second power voltage node VSSN may be connected to another one of the power lines PL of FIG. 1 and receives the second power voltage. The first power voltage may have a voltage level higher than that of the second power voltage.

The light emitting element LD may be connected between an anode electrode AE and a cathode electrode CE. The anode electrode AE may be connected to the first power voltage node VDDN through the sub-pixel circuit SPC. In an embodiment, for example, the anode electrode AE may be connected to the first power voltage node VDDN through one or more transistors included in the sub-pixel circuit SPC. The cathode electrode CE may be connected to the second power voltage node VSSN. The light emitting element LD may be configured to emit light according to a current flowing from the anode electrode AE to the cathode electrode CE.

The sub-pixel circuit SPC may be connected to an i-th gate line GLi among the first to m-th gate lines GL1 to GLm of FIG. 1, and a j-th data line DLj among the first to n-th data lines DL1 to DLn of FIG. 1. In response to a gate signal received through the i-th gate line GLi, the sub-pixel circuit SPC may control the light emitting element LD to emit light corresponding to a data signal received through the j-th data line DLj. In embodiments, the sub-pixel circuit SPC may be further connected to the pixel control lines PXCL of FIG. 1. In such embodiments, the sub-pixel circuit SPC may control the light emitting element LD in further response to the pixel control signals received through the pixel control lines PXCL.

For such operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal oxide semiconductor field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, or the like.

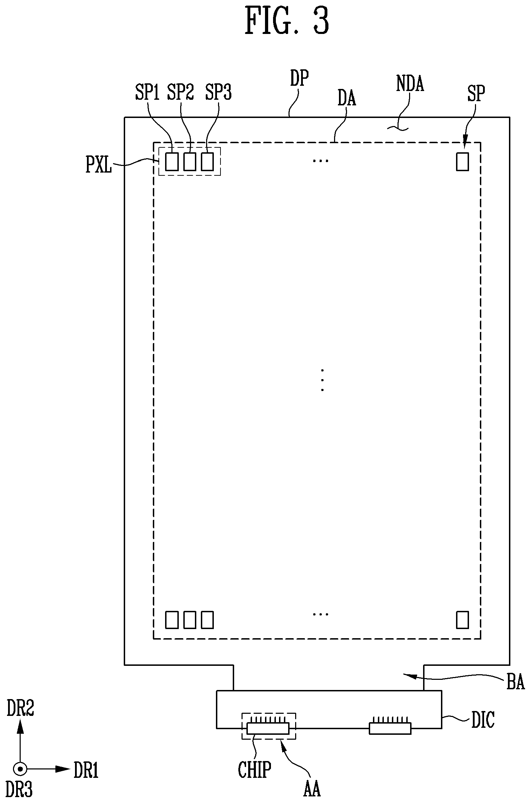

FIG. 3 is a plan view illustrating the display panel of the display device of FIG. 1.

Referring to FIG. 3, an embodiment of the display panel DP may include a display area DA and a non-display area NDA. The display panel DP may display an image through the display area DA. The non-display area NDA may be disposed around the display area DA and no image may be displayed through the non-display area NDA.

The display panel DP may include the sub-pixels SP disposed in the display area DA. The sub-pixels SP may be arranged along a first direction DR1 and a second direction DR2 crossing the first direction DR1. In an embodiment, for example, the sub-pixels SP may be arranged in a matrix form along the first direction DR1 and the second direction DR2. In another embodiment, for example, the sub-pixels SP may be arranged in a zigzag form along the first direction DR1 and the second direction DR2. An arrangement of the sub-pixels SP may vary according to embodiments. The first direction DR1 may be a column direction, and the second direction DR2 may be a row direction.

Two or more sub-pixels among the sub-pixels SP may configure or collectively define one pixel PXL. In an embodiment, as shown in FIG. 3, the pixel PXL includes three sub-pixels SP1, SP2, and SP3, but embodiments are not limited thereto. In another embodiment, for example, the pixel PXL may include two sub-pixels. Hereinafter, for convenience of description, embodiments where the pixel PXL includes the first to third sub-pixels SP1, SP2, and SP3 will be mainly described.

In an embodiment, each of the first to third sub-pixels SP1, SP2, and SP3 may generate light of one of various colors such as red, green, blue, cyan, magenta, and yellow. In such an embodiment, each of the first to third sub-pixels SP1, SP2, and SP3 may include at least one light emitting element configured to generate light. The light emitting element may be, for example, a micro scale or nano scale of light emitting diode or organic light emitting diode.

A component (or a plurality of components) for controlling the sub-pixels SP may be disposed in the non-display area NDA. Lines connected to the sub-pixels SP, for example, the first to m-th gate lines GL1 to GLm of FIG. 1, the first to n-th data lines DL1 to DLn, the power lines PL, and the pixel control lines PXCL may be disposed in the non-display area NDA.

At least one selected from the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. In such embodiments, the data driver 130, the voltage generator 140, and the controller 150 may be implemented as a driver integrated circuit DIC separated from the display panel DP. The driver integrated circuit DIC may be connected to the lines disposed in the non-display area NDA. In another embodiment, the gate driver 120 may be implemented as a driver integrated circuit DIC separated from the display panel DP, together with the data driver 130, the voltage generator 140, and the controller 150.

In embodiments, the display panel DP may include a bending area BA. The bending area BA may be positioned between the display area DA and the driver integrated circuit DIC. The display panel DP may be bent in the bending area BA. In such embodiments, the driver integrated circuit DIC may be disposed on a back surface of the display panel DP.

A driving chip CHIP may be mounted on the driver integrated circuit DIC. The driving chip CHIP may generate various driving signals for driving various components implemented as the driver integrated circuit DIC.

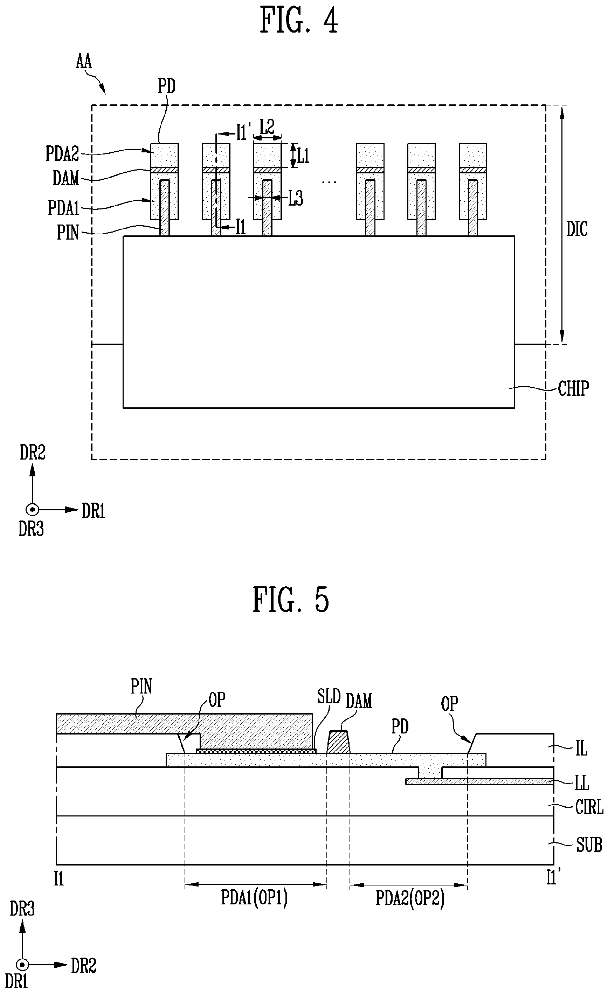

FIG. 4 is an enlarged plan view of an area AA of FIG. 3.

Referring to FIG. 4, in an embodiment, the driving chip CHIP may be mounted on the driver integrated circuit DIC.

The driver integrated circuit DIC may include a plurality of pads PD. The plurality of pads PD may be arranged along the first direction DR1. For example, the pads PD may be arranged in a row extending along the first direction DR1. The plurality of pads PD may be arranged to be spaced apart from each other at a regular distance. Each of the plurality of pads PD may be divided (or partitioned) into a first pad area PDA1 and a second pad area PDA2. In an embodiment, for example, the first pad area PDA1 and the second pad area PDA2 may be partitioned (or divided) by a dam structure DAM. The dam structure DAM may be arranged on a top surface of the pads PD. The first pad area PDA1 and the second pad area PDA2 may be electrically connected and, but a surface of the pad, e.g., a top surface of the pad oriented towards the contact pins PIN of the driving chip CHIP, may be divided (or partitioned) into the first pad area PDA1 and the second pad area PDA2.

In the plurality of pads PD, the second pad areas PDA2 may be arranged along the first direction DR1. For example, the second pad areas PDA2 may be arranged in a row along the first direction DR1. In an embodiment, a separation distance between adjacent second pad areas PDA2 among the second pad areas PDA2 may be constant.

The driving chip CHIP may include a plurality of contact pins PIN. Each of the plurality of contact pins PIN may extend in the second direction DR2. Each of the plurality of contact pins PIN max overlap with the first pad area PDA1 in the second direction. The plurality of contact pins PIN may be arranged along the first direction DR1. The plurality of contact pins PIN may be arranged to be spaced apart from each other at a regular distance.

The plurality of contact pins PIN may electrically contact the plurality of pads PD. In an embodiment, the plurality of contact pins PIN may correspond to the plurality of pads PD one-to-one.

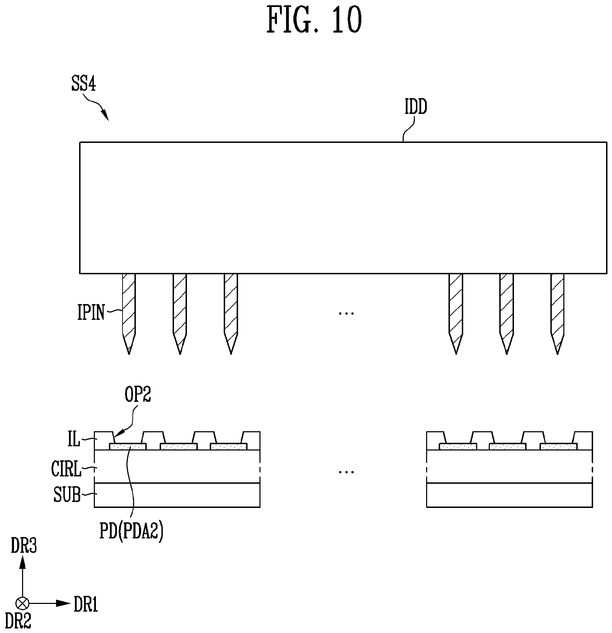

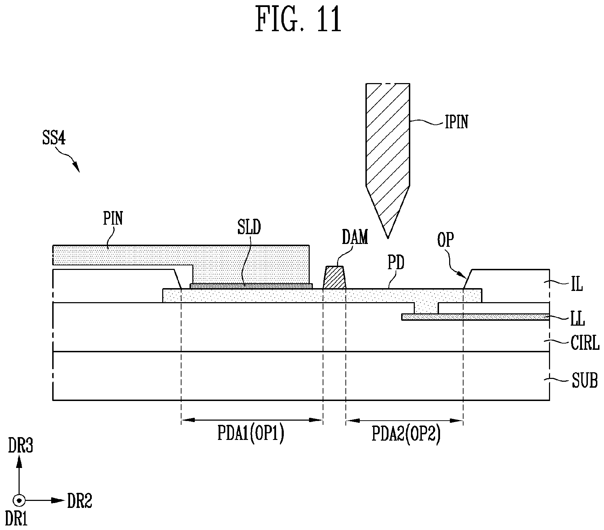

In an embodiment, each of the plurality of contact pins PIN may electrically contact the first pad area PDA1. In such an embodiment, the second pad area PDA2 may be an area where a test pin IPIN of a test device of FIGS. 10 and 11 for performing testing of the display device DD contacts the pad PD. If the second pad area PDA2 is not in contact with the contact pins PIN the space where a test pin IPIN may contact the surface of the pad PD is increased with respect to the known state of the art. In such an embodiment, the second pad area PDA2 may be arranged not to overlap the contact pin PIN in a plan view or when viewed in the third direction DR3. Here and throughout the rest of the description, the third direction DR3 (for example, the plan view direction) may be a direction perpendicular to the first direction DR1 and the second direction DR2, or a thickness direction of the display panel DP. Typically, multiple layers of the driver integrated circuit DIC may extend along the first and second directions and stack in the third direction. A length of the second pad area PDA2 in the second direction may be at least 30% or at least 50%, e.g. about 50%, of a length of the first pad area PDA1 in the second direction. A width of the second pad area PDA2 in the first direction may be the same as a width of the first pad direction PDA1 in the first direction. A surface of the second pad area PDA2 seen in a top view of the first area can be at least 30% or at least 50%, e.g. about 50%, of a respective surface of the first pad area PDA1.

In embodiments, each of the plurality of contact pins PIN may have a third width L3 in the first direction DR1. In such embodiments, a second width L2 in the first direction DR1 of the second pad area PDA2 may be greater than the third width L3. In an embodiment, for example, the second width L2 may be at least 1.5 times, at least 2 times, or about 1.5 times the third width L3. In such embodiments, a first width L1 in the second direction DR2 of the second pad area PDA2 may be greater than the third width L3. In an embodiment, for example, the first width L1 may be at least 1.5 times, at least 2 times, or about 1.5 times the third width L3. At the same time, for example, the second width L2 may be smaller than 5 times, e.g. about 3 times, the third width L3. Accordingly, the second pad area PDA2 may have a sufficient area for contact with the test pin of the test device described above.

In embodiments, the planar area of the second pad area PDA2 may be less thanthe planar area of the first pad area PDA1, for example, between 0.3 times and 0.7 times the planar area of the first pad area PDA1. In such embodiments, maximum space efficiency may be secured in the limited planar area of the driver integrated circuit DIC.

FIG. 5 is a cross-sectional view taken along line I1-I1' of FIG. 4.

Referring to FIGS. 4 and 5, an embodiment of the driver integrated circuit DIC may include a base substrate SUB, a first layer CIRL, a second layer IL, and a pad PD.

The base substrate SUB may include various materials. In an embodiment, for example, the base substrate SUB may include glass, plastic, or the like, but the disclosure is not limited thereto.

The first layer CIRL may be disposed on the base substrate SUB. The first layer CIRL may include lines for transmitting various types of electrical signals and various types of insulating layers sequentially disposed along the third direction DR3. Here, the third direction may be a thickness direction of the base substrate SUB. In an embodiment, for example, the first layer CIRL may include a line LL electrically connected to the pad PD. The line LL may be electrically connected to the sub-pixels SP or other components electrically connected to the sub-pixels SP.

The pad PD may be disposed on the first layer CIRL. In an embodiment, as shown in FIG. 5, the pad PD may be electrically connected to the line LL. In an embodiment, for example, the pad PD may electrically contact the line LL through a through hole defined or formed through some of the various types of insulating layers included in the first layer CIRL.

The second layer IL may be disposed on the first layer CIRL. The second layer IL may define an opening OP exposing an upper surface of the pad PD. A plurality of openings OP may be provided, and the plurality of openings OP may be positioned to correspond one-to-one to the plurality of pads PD of FIG. 4. The second layer IL may include an insulating material. In an embodiment, for example, the second layer IL may include an organic insulating material and/or an inorganic insulating material. The second layer IL may overlap, for example partially overlap, the pad PD.

The dam structure DAM may be disposed on the pad PD in the opening OP. By the dam structure DAM, the opening OP may be partitioned into a first opening OP1 and a second opening OP2. In such an embodiment, an area exposed by the first opening OP1 in the pad PD may be the first pad area PDA1, and an area exposed by the second opening OP2 may be the second pad area PDA2. The dam structure DAM may include an insulating material. In an embodiment, for example, the dam structure DAM may include an organic insulating material and/or an inorganic insulating material, and may be formed integrally with the second layer IL according to embodiments. In another embodiment, the dam structure DAM may include a conductive material. In an embodiment, for example, the dam structure DAM may include a same material as the pad PD. In embodiments, as described above, the dam structure DAM may include various types of materials.

The contact pin PIN of the driving chip CHIP may electrically contact the first pad area PDA1 of the pad PD. In an embodiment, the contact pin PIN may be bonded and fixed to the first pad area PDA1. In an embodiment, for example, a solder member SLD for bonding of the contact pin PIN may be disposed. The solder member SLD may be disposed in (or on) the first pad area PDA1. The solder member SLD may be received in the first opening OP1. In embodiments, the dam structure DAM may serve to block the solder member SLD, and thus the solder member SLD may not be disposed in the second pad area PDA2. In other words, the dam structure DAM may prevent solder, for example liquid solder, from being present, or from reaching, the second pad area PDA2. In such embodiments, when the test pin of the test device described above contacts the second pad area PDA2, reduction of contact reliability that may occur due to existence of the solder member SLD in the second pad area PDA2 may be effectively prevented.

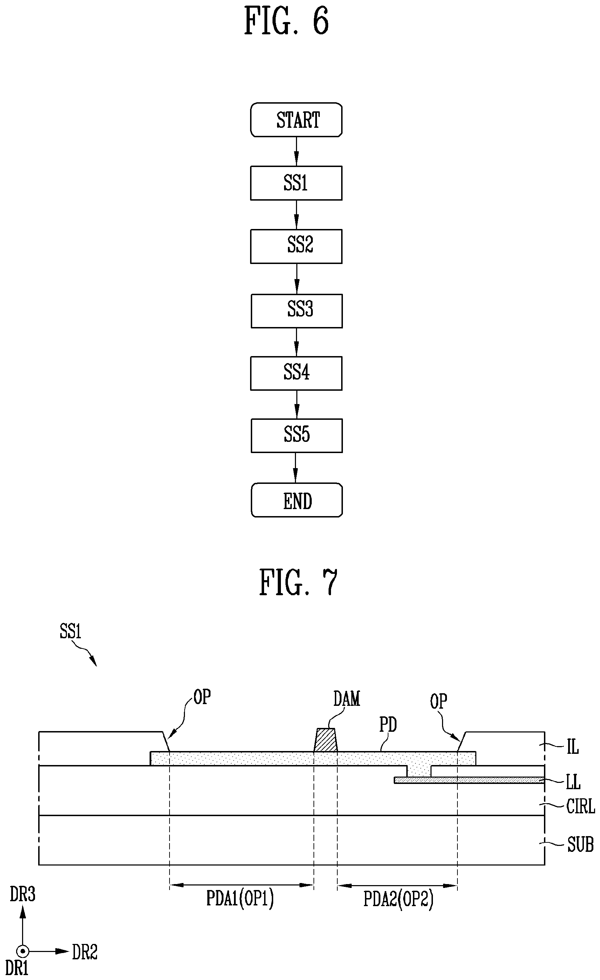

FIGS. 6 to 12 are diagrams illustrating an embodiment of a test method for testing the display panel of FIG. 3.

Referring to FIG. 6, an embodiment of a method of testing the display panel may include first to fifth processes SS1, SS2, SS3, SS4, and SS5. The first process SS1 may be a process of preparing the display panel DP including the driver integrated circuit DIC. The second and third processes SS2, SS3 may be processes of mounting the driving chip CHIP on the driver integrated circuit DIC. The fourth and fifth processes SS4 and SS5 may be processes of testing whether the display panel DP is defective using a test device.

Referring to FIG. 7, the first process SS1 may be performed. In such a process, the display panel DP including the driver integrated circuit DIC may be provided. FIG. 7 shows a cross-section of a partial area of the driver integrated circuit DIC described with reference to FIG. 5.

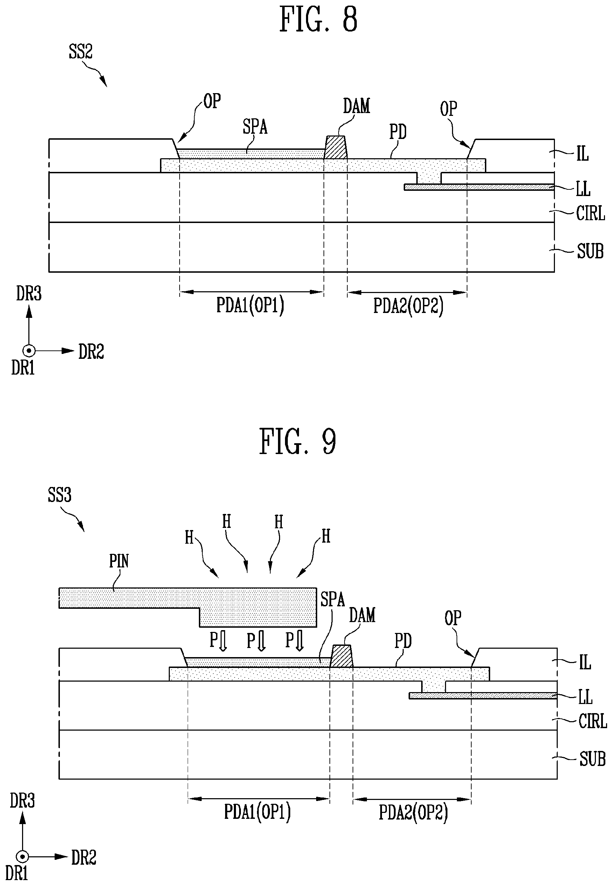

Referring to FIG. 8, the second process SS2 may be performed. In such a process, solder paste SPA may be provided in the first opening OP1. The solder paste SPA may include the solder member SLD of FIG. 5 and flux. In this case, the dam structure DAM may serve to block the solder paste SPA, for example from reaching the second pad area PDA2. Accordingly, the solder paste SPA may not be provided to the second opening OP2.

Referring to FIG. 9, the third process SS3 may be performed. In such a process, the contact pin PIN of the driving chip CHIP may be pressed P in a direction opposite to the third direction DR3, e.g., in a vertical direction. Accordingly, the contact pin PIN may electrically contact the first pad area PDA1. In an embodiment, heat H may be applied to the solder paste SPA in the first opening OP1. Accordingly, the flux in the solder paste SPA may be volatilized, and the contact pin PIN may be bonded to the first pad area PDA1 by a remaining solder member SLD.

Referring to FIGS. 10 and 11, the fourth process SS4 may be performed. In such a process, a test device IDD may be provided. The test device IDD may include a plurality of test pins IPIN. Each of the plurality of test pins IPIN may extend in the direction opposite to the third direction DR3. The plurality of test pins IPIN may have a constant height in the third direction DR3. The plurality of test pins IPIN may be arranged, for example in a row, along the first direction DR1. The plurality of test pins IPIN may be arranged to be spaced apart from each other at a regular distance.

In an embodiment, the plurality of test pins IPIN may be provided to correspond to the plurality of pads PD with a one-to-one correspondence. In such an embodiment, the plurality of test pins IPIN may be aligned on the second pad areas PDA2 of the plurality of pads PD.

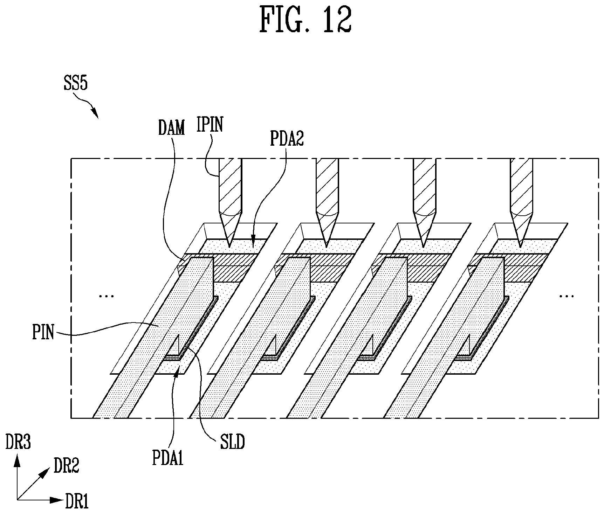

Referring to FIG. 12, the fifth process SS5 may be performed. In such a process, the plurality of test pins IPIN may contact the second pad areas PDA2 of the plurality of pads PD. The test device IDD may provide a test image signal to the plurality of pads PD through the plurality of test pins IPIN. Based on the test image signal, a test image may be displayed in the display area DA (refer to FIG. 3). Based on the test image, a connection defect of the driving chip CHIP may be determined. In such a process, when a defect is sensed in the test image, it may be determined that a connection between the contact pin PIN of the driving chip CHIP and the pad PD is defective.

Each of the plurality of test pins IPIN may contact the second pad area PDA2 partitioned from the first pad area PDA1. Accordingly, the plurality of test pins IPIN and the plurality of pads PD may be electrically (and respectively) connected to each other. In such an embodiment, since the second pad area PDA2 may have a sufficient area for the contact described above, contact reliability of the plurality of test pins IPIN may be improved.

In a test method known from the state of the art in which the plurality of test pins IPIN contact the plurality of contact pins PIN, since the width L3 (refer to FIG. 4) of the first direction DR1 of each of the plurality of contact pins PIN is relatively small, contact difficulty for contacting the plurality of test pins IPIN to the plurality of contact pins PIN may increase. In addition, an alignment defect in which the plurality of contact pins PIN are not provided at a regular distance may occur due to various factors. In this case, a problem that some of the plurality of test pins IPIN provided at a regular distance do not contact the contact pin PIN having the alignment defect may occur. That is, contact reliability of the plurality of test pins IPIN may be reduced.

In addition, in a test method known from the state of the art in which the plurality of test pins IPIN contact the first pad area PDA1, since the plurality of contact pins PIN are bonded to the first pad area PDA1, a position of the plurality of test pins IPIN may be limited by the plurality of contact pins PIN. That is, contacting the plurality of test pins IPIN to the first pad area PDA1 may not be easy.

In a test method known from the state of the art in which the plurality of test pads electrically connected to the plurality of pads PD through a line (for example, LL, refer to FIG. 5) are separately provided on the driver integrated circuit DIC and the plurality of test pins IPIN contact the plurality of test pads, an area for providing the plurality of test pads may be forced, e.g., additional are for providing the test pads may be needed, and thus a problem that space efficiency of the driver integrated circuit DIC is reduced may occur.

In embodiments of the disclosure, as described above, each of the plurality of test pins IPIN may contact the second pad area PDA2 partitioned from the first pad area PDA1 by the dam structure DAM. Accordingly, the plurality of test pins IPIN and the plurality of pads PD may be electrically (and respectively) connected to each other. In such an embodiment, since the second pad area PDA2 may have a sufficient area for the contact, contact reliability of the plurality of test pins IPIN may be improved.

Although described with reference to the above embodiments, it will be understood that those skilled in the art can variously modify and change the disclosure without departing from the scope of the disclosure described in the claims below.

## Claims

1. A display device (DD) comprising:
a display panel (DP) including a plurality of pixels (PXL) disposed in a display area (DA); and
a driver integrated circuit (DIC) electrically connected to the plurality of pixels (PXL), wherein the driver integrated circuit (DIC) includes a plurality of pads (PD) spaced apart from each other, and a driving chip (CHIP) including a plurality of contact pins (PIN) electrically contacting the plurality of pads (PD), respectively,
wherein each of the plurality of pads (PD) comprises:
a first pad area (PDA1) electrically contacting a corresponding contact pin (PIN) among the plurality of contact pins (PIN); and
a second pad area (PDA2) partitioned from the first pad area (PDA1) and not overlapping the corresponding contact pin (PIN) in a plan view.

2. The display device (DD) according to claim 1, wherein in the plan view, a width of the corresponding contact pin (PIN) in a first direction is less than a width of the second pad area (PDA2) in the first direction, and
the first direction is a direction perpendicular to a second direction, which is an extension direction of the corresponding contact pin (PIN).

3. The display device (DD) according to claim 1 or claim 2, wherein in the plan view, a width of the second pad area (PDA2) in the second direction is greater than the width of the corresponding contact pin (PIN) in the first direction.

4. The display device (DD) according to one of claims 1 to 3, wherein second pad areas (PDAs) of the plurality of pads (PD) are arranged along the first direction.

5. The display device (DD) according to one of claims 1 to 4, wherein a separation distance between adjacent second pad areas (PDA2) among the second pad areas (PDA2) is constant.

6. The display device (DD) according to one of claims 1 to 5, wherein in the plan view, an area of the second pad area (PDA2) is less than an area of the first pad area (PDA1).

7. The display device (DD) according to one of claims 1 to 6, wherein the driver integrated circuit (DIC) further includes:
a first layer (CIRL) disposed under the plurality of pads (PD); and
a second layer (IL) disposed on the first layer (CIRL), covering an edge of each of the plurality of pads (PD), and defining an opening (OP) exposing an upper surface of each of the plurality of pads (PD).

8. The display device (DD) according to one of claims 1 to 7, wherein the driver integrated circuit (DIC) further includes a dam structure (DAM) disposed between the first pad area (PDA1) and the second pad area (PDA2) in the opening (OP).

9. The display device (DD) according to claim 8, wherein the dam structure (DAM) partitions the opening (OP) into a first opening (OP1) and a second opening (OP2),
the first opening (OP1) exposes the first pad area (PDA1), and
the second opening (OP2) exposes the second pad area (PDA2).

10. The display device (DD) according to one of claims 1 to 9, wherein the driver integrated circuit (DIC) further includes a solder member (SLD) disposed in the first pad area (PDA1) of each of the plurality of pads (PD), wherein each of the plurality of pads (PD) is bonded to the corresponding contact pin (PIN) by the solder member (SLD).

11. A method of testing a display device (DD),
wherein the display device (DD) comprises:
a display panel (DP) including a plurality of pixels (PXL) disposed in a display area (DA); and
a driver integrated circuit (DIC) including a plurality of pads (PD) spaced apart from each other, and a driving chip (CHIP) including a plurality of contact pins (PIN) electrically contacting the plurality of pads (PD), and electrically connected to the plurality of pixels (PXL),
wherein each of the plurality of pads (PD) comprises:
a first pad area (PDA1) electrically contacting the contact pin (PIN); and
a second pad area (PDA2) partitioned from the first pad area (PDA1) and nonoverlapping the contact pin (PIN) in a plan view, and
the method comprises contacting a plurality of test pins (IPIN) to the plurality of pads (PD).

12. The method according to claim 11, wherein each of the plurality of test pins (IPIN) contacts the second pad area (PDA2).

13. The method according to claim 11 or claim 12, wherein the plurality of test pins (IPIN) correspond to the plurality of pads (PD) one-to-one.

14. The method according to claim one of claims 11 to 13, further comprising:
displaying a test image in the display area (DA) based on a test image signal provided from the plurality of test pins (IPIN); and
determining a connection defect of the driving chip (CHIP) based on the test image.

15. The method according to claim 14, wherein the test image signal is provided to the plurality of second pad areas (PDA2) of the pads PD through the plurality of test pins (IPIN).
